# EUROPÄISCHE PATENTSCHRIFT

(11) **EP 1 547 149 B1**
(45) Veröffentlichungstag und Bekanntmachung des Hinweises auf die Patenterteilung: **07.11.2018**
(21) Anmeldenummer: 03753272.8
(22) Anmeldetag: 01.09.2003
(51) Int. Cl.: G02F 1/133, H01L 25/075, H01L 33/58, H01L 33/60

(54) **HEAD-UP-DISPLAY MIT EINER EINRICHTUNG ZUR ERZEUGUNG EINES GEBÜDELTEN LICHTSTROMS**
HEAD-UP DISPLAY WITH AN ARRANGEMENT FOR PRODUCING A BUNDLED LIGHT FLUX
AFFICHAGE TÊTE HAUTE AVEC UNE CONSTRUCTION POUR PRODUIRE UN FAISCEAU LUMINEUX

(30) Priorität: 30.09.2002 DE 10245933
(43) Veröffentlichungstag der Anmeldung: 29.06.2005
(73) Patentinhaber: OSRAM Opto Semiconductors GmbH, 93055 Regensburg (DE)
(72) Erfinder: BOGNER, Georg, 93138 Hainsacker (DE); BREINICH, Herbert, 65205 Wiesbaden (DE); LUDEWIG, Bernd, 69493 Hirschberg (DE); MAYER, Ralf, 67295 Bolanden (DE); NOLL, Heinrich, 64823 Gross-Umstadt (DE); SORG, Jörg, Erich, 93053 Regensburg (DE)
(74) Vertreter: Patentanwaltskanzlei WILHELM & BECK
(86) Internationale Anmeldenummer: PCT/DE2003/002891
(87) Internationale Veröffentlichungsnummer: WO 2004/032235

(56) Entgegenhaltungen:
- WO-A-00/70687
- WO-A-02/05351
- WO-A-02/17405
- WO-A-02/33756
- WO-A1-2004/031843
- US-A- 4 935 665
- US-A- 5 043 716
- US-A- 5 836 676
- PATENT ABSTRACTS OF JAPAN Bd. 1995, Nr. 08, 29. September 1995 (1995-09-29) -& JP 07 130256 A (KYOCERA CO), 19. Mai 1995 (1995-05-19)

## Beschreibung

Die Erfindung betrifft ein Head-Up-Display mit einer Einrichtung zur Erzeugung eines gebündelten Lichtstroms.

Um Fahrzeugführern Informationen zu übermitteln, ohne dass diese ihren Blick von der zu befahrenden Straße oder dem zu befliegenden Luftraum abwenden müssen, sind so genannte Head-up-Displays bekannt geworden, mit denen ein die Informationen darstellendes Bild in die Frontscheibe eines Fahrzeugs eingeblendet wird. Damit es auch noch bei hellem Umgebungslicht sichtbar ist, ist dazu eine hohe Leuchtdichte des Bildes erforderlich. Auch für andere Beleuchtungszwecke werden gebündelte Lichtströme benötigt, beispielsweise als Leselampen oder als Strahler für Schaufenster und Ausstellungen.

Displays mit einer Einrichtung zur Erzeugung eines gebündelten Lichtstroms sind bereits aus den Patentschriften US 5, 836, 676 und US 5, 043, 716 und der Offenlegungsschrift JP H07-130256, jeweils in einer Anwendung für eine Anzeige bekannt. Ein Display mit einer Lichtventil enthaltenden Bildwiedergabevorrichtung ist aus der Offenlegungsschrift WO 02/17405 bekannt. Eine Leuchte mit Bündelung des Lichtstrahles ist aus der Patentschrift US 4, 935, 665 bekannt. Die gezeigten Anordnungen weisen jedoch aufgrund ihrer jeweiligen Bündelungs- und Streunungscharakteristik kaum Eignung für eine Verwendung in einem Head-Up-Display auf.

Aufgabe der Erfindung ist es daher, einen Lichtstrom mit Einrichtungen zu erzeugen, welche insbesondere eine geringe Baugröße und geringes Gewicht aufweisen, möglichst wenig Verlustleistung aufnehmen bzw. als Wärme abgeben und somit auch für den Betrieb in einem Fahrzeug geeignet sind.

Diese Aufgabe wird erfindungsgemäß durch die in Anspruch 1 angeführten Merkmale gelöst.

Bei der erfindungsgemäßen Einrichtung hat es sich als günstig herausgestellt, wenn jeweils ein Matrixpunkt von mehreren Leuchtdioden gebildet wird, die auch verschiedenfarbig sein können.

Eine kostengünstige Fertigung der erfindungsgemäßen Einrichtung ist dadurch möglich, dass die Sammellinsen aller Lichtkanäle einstückig mit einer zwischen der Lichtquelle und dem gitterförmigen Reflektor angeordneten Platte verbunden sind.

Eine vorteilhafte Ausgestaltung der Erfindung besteht darin, dass die Krümmungsradien der Linse in unterschiedlichen Richtungen verschieden sind (astigmatische Linsen). Dadurch kann die Lichtverteilung insbesondere in länglichen Lichtaustrittsöffnungen verbessert werden.

Die an der Lichtaustrittsöffnung angeordnete Lichtventile enthaltende Bildwiedergabevorrichtung ermöglicht eine kompakte Einrichtung für die Erzeugung hoch auflösender Bilder mit hoher Leuchtdichte und gleichmäßiger Leuchtdichteverteilung über die gesamte Bildfläche. Dabei sorgt die Einrichtung zur Bündelung und Streuung dafür, dass das von den Leuchtdioden erzeugte Licht auf die Fläche der Bildwiedergabevorrichtung konzentriert wird, ohne dass eine störende Abbildung der einzelnen Leuchtdioden erfolgt. Ein bevorzugtes Anwendungsgebiet der erfindungsgemäßen Einrichtung sind graphische Head-up-Displays für Fahrzeuganwendungen.

Mit der Bildwiedergabevorrichtung weist die erfindungsgemäße Einrichtung noch einige im Folgenden aufgeführte Vorteile auf. So wird durch die Abstimmung zwischen RGB-Lichtquelle und Farbdisplay die Darstellung von graphischen Farbbildern in einem Head-up-Display bei ausreichender Leuchtdichte ermöglicht. Im Zusammenspiel mit dem Reflektor und der Linse wird eine gleichmäßige Farb- und Leuchtdichte-Verteilung der Hinterleuchtung auf der Fläche des Flüssigkristall-Displays erreicht.

Im Flüssigkristall-Farbdisplay können konfigurierbare Bildinhalte farbig dargestellt werden. Der Bildinhalt kann somit an die Fahrsituation angepasst werden. Der Bauraum für die gesamte Bilderzeugungseinrichtung beträgt beim praktisch ausgeführten Beispiel nur wenige Kubikzentimeter. Durch die Wahl der Farben der Leuchtdioden und des dazugehörigen Displays kann der jeweils darzustellende Farbraum beeinflusst werden. Beispielsweise kann anstelle eines RGB-Leuchtdioden-Rasters ein Rot-Grün-Leuchtdioden-Raster gewählt werden und in entsprechender Weise im Flüssigkristall-Display die blauen Filterelemente durch grüne ersetzt werden. Dann ergibt sich ein eingeschränkter Farbraum mit nochmals deutlich erhöhter Leuchtdichte.

Die Erfindung lässt zahlreiche Ausführungsformen zu. Mehrere davon sind schematisch in der Zeichnung anhand mehrerer Figuren dargestellt und nachfolgend beschrieben. Es zeigt:
- Fig. 1: einen Schnitt durch ein Ausführungsbeispiel,
- Fig. 2: eine Draufsicht auf den gitterförmigen Reflektor bei dem Ausführungsbeispiel nach Fig. 1,
- Fig. 3: einen Schnitt durch ein nicht erfindungsgemäßes Beispiel,
- Fig. 4: eine vergrößerte Darstellung eines Ausschnitts aus Fig. 1 zur Erläuterung verschiedener Details,
- Fig. 5: eine vergrößerte Darstellung eines Ausschnitts eines anderen Ausführungsbeispiels und
- Fig. 6: ein Teil eines nicht erfindungsgemäßen Linsenrasters.

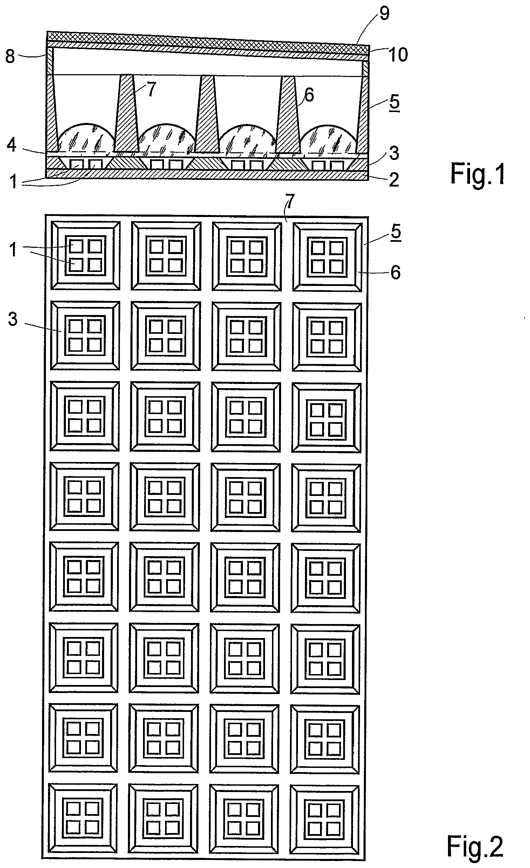

Bei dem Ausführungsbeispiel nach den Figuren 1 und 2 ist als Lichtquelle ein Raster von 4 x 8 Gruppen von jeweils vier Leuchtdioden 1 vorgesehen, die auf einem Träger 2 montiert sind. Zwischen den Gruppen befinden sich Stege 3, deren schräg stehende Oberfläche als Reflektor dient.

Über der Lichtquelle 1, 2, 3 liegt ein Linsenraster 4, an das sich ein gitterförmiger Reflektor 5 anschließt.

Die Stege 3, das Linsenraster 4 sowie die schräg verlaufenden Oberflächen 6 des gitterförmigen Reflektors 5 bewirken eine gleichförmige Lichtverteilung. Um Abschattungen durch die Stege 7 des Reflektors 5 zu vermeiden, ist ein Rahmen 8 vorgesehen, der einen Abstand zwischen dem Reflektor 5 und dem Flüssigkristall-Display 9 bewirkt. Unterhalb des Flüssigkristall-Displays 9 befindet sich eine Streuscheibe 10, um die Gleichförmigkeit der Hinterleuchtung des Flüssigkristall-Displays 9 weiter zu verbessern.

Der Rahmen 8 bewirkt eine Schrägstellung des Flüssigkristall-Displays, so dass von oben einfallendes Licht nicht in der gleichen Richtung reflektiert wird, in der auch das Licht das Flüssigkristall-Display verlässt, um zum Betrachter zu gelangen.

Fig. 2 zeigt die Einrichtung nach Fig. 1 bei abgenommenen Flüssigkristall-Display 9 und bei abgenommener Streuscheibe 10. Die Leuchtdioden 1 sind bei der Darstellung nach Fig. 2 an sich durch das Linsenraster 4 sichtbar. Der Einfachheit halber wurde jedoch eine entsprechende Verzerrung der Leuchtdioden 1 nicht dargestellt.

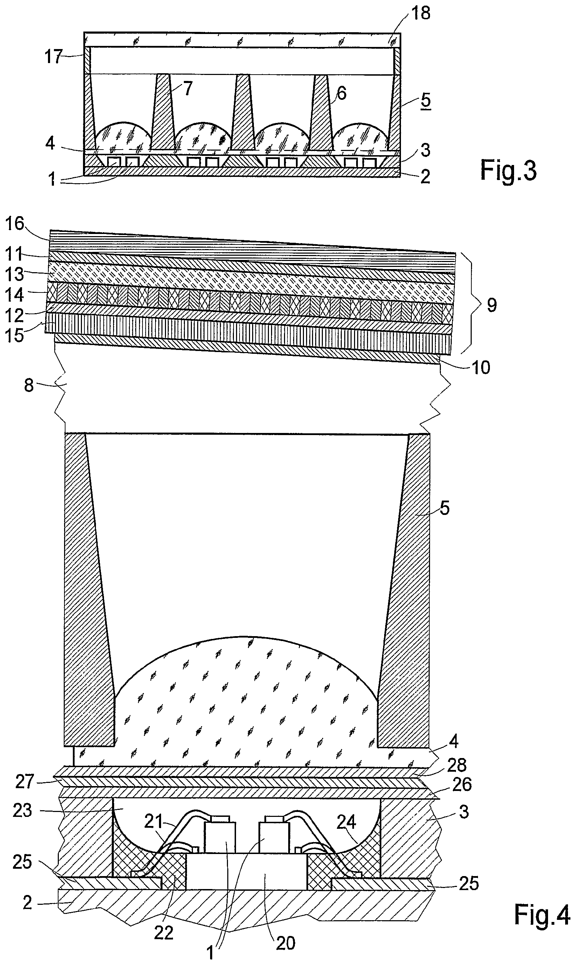

Das Ausführungsbeispiel nach Fig. 3 stellt eine Beleuchtungseinrichtung dar, bei welcher die Lichtaustrittsöffnung aus einer Glasplatte 18 besteht, die auf einem Rahmen 17 ruht. Ansonsten ist dieses Ausführungsbeispiel wie dasjenige nach Fig. 1 aufgebaut.

Fig. 4 stellt im Wesentlichen eine Ausschnittsvergrößerung aus Fig. 1 dar und dient zur Erläuterung von Einzelheiten des Flüssigkristall-Displays und der Lichtquelle. Das Flüssigkristall-Display 9 weist zwischen zwei Glasplatten 11, 12 einen Flüssigkristall 13 sowie ein Farbfilter 14 auf. Letzteres besteht aus einem Raster von drei verschiedenfarbigen Farbpunkten, was in Fig. 4 durch unterschiedliche Schraffur gekennzeichnet ist. Korrelierend mit dem Raster des Farbfilters sind nicht dargestellte Steuerelektroden vorgesehen, welche jeweils mit dem Flüssigkristall ein Lichtventil bilden. Außerhalb der Glasplatten 11, 12 befinden sich Polarisatoren 15, 16 mit zueinander senkrecht stehenden Polarisationsebenen.

Die im Zusammenhang mit Fig. 1 kurz beschriebene Lichtquelle ist in Fig. 4 ebenfalls detaillierter dargestellt.

Vier Leuchtdioden 1 sind erhöht in der Mitte eines von Stegen 3 gebildeten Loches auf einem Submount 20 angeordnet. Die Leuchtdioden sind über Bonddrähte 21 mit Leitungen 25 verbunden, die lediglich schematisch durch Schraffur der von ihnen eingenommenen Fläche dargestellt sind. In einer bevorzugten Ausführungsform ist eine der Leuchtdioden rot leuchtend, zwei sind grün leuchtend und die vierte leuchtet blau. Bei dieser Anordnung mischt sich das Licht zu weiß. Der Raum zwischen dem Submount 20 und den Stegen 3 ist mit einer weißen Vergussmasse 22 aufgefüllt, deren Oberfläche 24 als Reflektor für das seitlich von den Leuchtdioden 1 ausgestrahlte Licht dient. Eine transparente Vergussmasse 23 verhindert die Bildung eines Hohlraumes.

Die Verbindung zwischen der Lichtquelle 1, 2, 3 und dem Linsenraster 4 erfolgt bei dem in Fig. 4 dargestellten Ausführungsbeispiel über eine Schicht 26 aus Silikongel, eine PCF-Schicht 27 und einen geeigneten Kleber 28.

Die PCF-Schicht 27 bewirkt, dass von dem mit Hilfe der Leuchtdioden erzeugte Licht nur dasjenige hindurch gelassen wird, das in Richtung des unteren Polarisators 15 polarisiert ist, so dass durch die Polarisation in der PCF-Schicht 27 kein Licht verloren geht. Das anders polarisierte Licht wird von der PCF-Schicht 27 reflektiert und anschließend von der Oberfläche 24 remittiert. Davon gelangt wiederum der Anteil mit der entsprechenden Polarisation zusätzlich durch die PCF-Schicht 27, so dass die PCF-Schicht insgesamt zu einer Erhöhung der Helligkeit beiträgt.

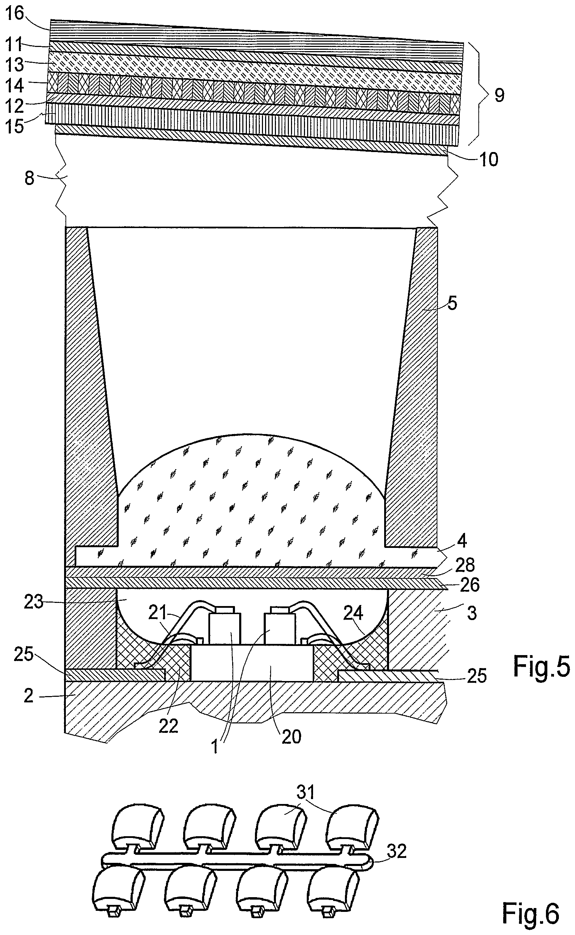

Fig. 5 zeigt ein Ausführungsbeispiel ohne eine PCF-Schicht. Außerdem befindet sich in Fig. 5 der dargestellte Ausschnitt am Rand der Einrichtung.

Fig. 6 zeigt ein nicht erfindungsgemäßes Linsenraster 31 mit acht Linsen, die durch Stege 32 zusammengehalten werden.

## Patentansprüche

1. Head-Up-Display mit einer Einrichtung zur Erzeugung eines gebündelten Lichtstroms, wobei eine Lichtquelle, bestehend aus einer Leuchtdioden-Matrix (1, 2, 3), vorgesehen ist, wobei zwischen der Lichtquelle und einer Lichtaustrittsöffnung (9, 18) eine optische Einrichtung zur Bündelung und Streuung des von den Leuchtdioden erzeugten Lichts angeordnet ist, wobei die Einrichtung zur Bündelung und Streuung einen gitterförmigen Reflektor (5) umfasst, der jeweils für einen Matrixpunkt einen Lichtkanal bildet, und das der Lichtquelle (1, 2, 3) zugewandte Ende jeweils eines Lichtkanals eine Sammellinse (4) enthält, wobei die Wände (6) des Lichtkanals reflektierend sind, wobei an der Lichtaustrittsöffnung eine Lichtventile enthaltende Bildwiedergabevorrichtung (9) angeordnet ist, und wobei die Sammellinsen (4) aller Lichtkanäle einstückig mit einer zwischen der Lichtquelle (1, 2,3) und dem gitterförmigen Reflektor (5) angeordneten Platte verbunden sind.

## Claims

1. Head-up display comprising a device for generating a focussed luminous flux, wherein a light source, consisting of a light-emitting diode matrix (1, 2, 3), is provided, wherein an optical device for focussing and scattering the light generated by the light-emitting diodes is arranged between the light source and a light emission opening (9, 18), wherein the device for focussing and scattering comprises a grid-shaped reflector (5), which forms a light channel in each case for a matrix point, and that end of a respective light channel which faces the light source (1, 2, 3) contains a converging lens (4), wherein the walls (6) of the light channel are reflective, wherein an image reproduction apparatus (9) containing light valves is arranged at the light emission opening, and wherein the converging lenses (4) of all the light channels are integrally connected to a plate arranged between the light source (1, 2, 3) and the grid-shaped reflector (5).

## Revendications

1. Affichage tête haute, disposant d'un système destiné à créer un flux lumineux en faisceau, une source lumineuse, constituée d'une matrice de diodes électroluminescentes (1, 2, 3), étant prévue, entre la source lumineuse et un orifice de sortie de lumière (9, 18) étant placé un système optique, destiné à concentrer et à disperser la lumière générée par les diodes électroluminescentes, le système destiné à concentrer et à disperser comprenant un réflecteur (5) en forme de grille, qui pour chaque fois un point de matrice forme un canal lumineux, et l'extrémité faisant face à la source lumineuse (1, 2, 3) de chaque fois un canal lumineux contenant une lentille convergente (4), les parois (6) du canal lumineux étant réfléchissantes, sur l'orifice de sortie de lumière étant placé un dispositif de reproduction d'image (9) contenant des modulateurs de lumière et les lentilles convergentes (4) de tous le canaux lumineux étant reliées en monobloc avec une plaque placée entre la source lumineuse (1, 2, 3) et le réflecteur (5) en forme de grille.
